# EUROPEAN PATENT APPLICATION

(11) **EP 4 793 777 A1**
(43) Date of publication of application: **19.08.2026**
(21) Application number: 26158109.4
(22) Date of filing: 12.02.2026
(51) Int. Cl.: G06F 11/26, G06F 11/22, G01R 31/28, G06F 15/78, G11C 29/04, G06F 30/333

(54) **DYNAMICALLY LOADING ENDPOINT DATA DURING SYSTEM-ON-CHIP (SOC) VALIDATION IN PROCESSOR-BASED DEVICES**

(30) Priority: 13.02.2025 US 202519053184
(71) Applicant: Microsoft Technology Licensing, LLC, Redmond, WA 98052 (US)
(72) Inventor: DEY, Dibyendu, Redmond, Washington, 98052 (US); REDDY, Vanila Chintha, Redmond, Washington, 98052 (US); WHITE, Jarred Joseph, Redmond, Washington, 98052 (US); BAIK, Dong Hyun, Redmond, Washington, 98052 (US); WOOD, Charles Parker, Redmond, Washington, 98052 (US); KNIGHT, Samuel Chelsae, Redmond, Washington, 98052 (US)
(74) Representative: CMS Cameron McKenna Nabarro Olswang LLP

(57) **Abstract**

Dynamically loading endpoint data during System-on-Chip (SoC) validation in processor-based devices is disclosed herein. In one exemplary embodiment, a processor-based device, by executing an SoC validator, obtains a path for an endpoint node of an endpoint tree data structure. The path comprises node identifiers including a root node identifier of a root node, intermediate node identifiers of corresponding intermediate nodes, and an endpoint node identifier of the endpoint node, and corresponds to a hierarchical path from the root node of the endpoint tree data structure to the endpoint node. The SoC validator traverses the endpoint tree data structure from the root node to the endpoint node based on the path, and retrieves value data for the endpoint node based on the traversal. The SoC validator then generates an endpoint object representing the endpoint using the value data, and performs an access operation on an endpoint using the endpoint object.

## Description

### Field of the Disclosure

The technology of the disclosure relates to System-on-Chip (SoC) validation in processor-based devices, and, more particularly, to efficient loading of SoC endpoint data during validation.

### Background

Systems-on-Chip (SoCs) are integrated circuits that combine multiple components such as processors, memory, and peripheral devices onto a single chip. Due to their inherent complexity, SoCs conventionally undergo validation to ensure that all components function correctly, interact with other components properly, meet performance targets for speed and power consumption, and are sufficiently reliable. SoC validation thus ensures that an SoC is safe and dependable, avoids potential malfunctions, and reaches the market in timely fashion.

One aspect of SoC validation involves accessing architectural endpoints of the SoC, such as debug and status registers via a test access port such as Joint Test Action Group (JTAG). Conventional approaches to SoC validation may use a static database of endpoint data (that is pre-generated based on the design specifications of the SoC) to generate an endpoint object for each endpoint before validation begins. Such endpoint objects may comprise software elements that include object attributes such as the endpoint's name, address, offset, and width, and may further provide methods for performing access operations, such as read operations and/or write operations, on the endpoint. However, modem SoCs may contain massive numbers of endpoints (e.g., on the order of millions to tens of millions), which results in correspondingly large volumes of formatted data defining the endpoints. Because conventional approaches to SoC validation construct endpoint objects for all possible endpoints during initialization, they may face a severe delay before validation can begin, due to the extensive time and memory required to load and initialize each and every endpoint object.

Accordingly, it is desirable to provide a more efficient mechanism for loading and accessing endpoint data during SoC validation.

### Summary

Exemplary embodiments disclosed herein dynamically load endpoint data during System-on-Chip (SoC) validation in processor devices. In this regard, in one exemplary embodiment, a processor-based device is communicatively coupled to an SoC and is configured to execute an SoC validator to perform validation and/or debugging operations on the SoC. In exemplary operation, the SoC validator obtains a path for an endpoint node of an endpoint tree data structure comprising a plurality of nodes including the endpoint node. In some embodiments, the endpoint node corresponds to an architectural endpoint of the SoC, which may comprise, e.g., a register, a field, or memory of the SoC accessed via a Joint Test Action Group (JTAG) port. The path obtained by the SoC may comprise a plurality of node identifiers including a root node identifier of a root node, one or more intermediate node identifiers of a corresponding one or more intermediate nodes, and an endpoint node identifier of the endpoint node. Some aspects may provide that the path corresponds to a hierarchical path from the root node of the endpoint tree data structure to the endpoint node (reflecting a path of a signal from a debugger entry point of the SoC to the endpoint).

The SoC validator next traverses the endpoint tree data structure from the root node to the endpoint node based on the path. Upon reaching the endpoint node, the SoC validator retrieves value data for the endpoint node based on the traversal. The value data includes all data required to generate an endpoint object, and may comprise, e.g., an endpoint name, a field identifier, a field read/write indicator, a current value of a field, and/or a child node name, as non-limiting examples. The SoC validator then generates an endpoint object representing the endpoint using the value data. The endpoint object according to some embodiments may comprise a Python object. In some embodiments, the operations for generating the endpoint object may comprise the SoC validator initializing one or more object attributes of the endpoint object based on the value data. The SoC validator then performs an access operation on the endpoint using the endpoint object. By dynamically loading only data for the endpoint and generating the single endpoint object on-demand (instead of generating endpoint objects for all of the endpoints during initialization), the startup time, memory consumption, and overall efficiency of the SoC validator is improved.

Some embodiments may provide that, prior to the SoC validator obtaining the path, an endpoint database that comprises data that defines the plurality of endpoints of the SoC may be converted into the endpoint tree data structure having a topology defined by hierarchical relationships among the plurality of endpoints of the SoC. The data defining the endpoint tree data structure is then stored in an endpoint tree database, which is subsequently accessed by the SoC validator during traversal of the endpoint tree data structure. In some embodiments, the endpoint tree database may comprise a lightweight, local disk database such as a Lightning Memory-Mapped Database (LMDB).

In another exemplary embodiment, a processor-based device configured to dynamically load endpoint data during SoC validation is provided. The processor-based device is configured to obtain, by executing an SoC validator, a path for an endpoint node, corresponding to an endpoint of a plurality of endpoints of an SoC, of a plurality of nodes of an endpoint tree data structure, wherein the path comprises a plurality of node identifiers comprising a root node identifier of a root node of the plurality of nodes, one or more intermediate node identifiers of a corresponding one or more intermediate nodes of the plurality of nodes, and an endpoint node identifier of the endpoint node, and the path corresponds to a hierarchical path from the root node of the endpoint tree data structure to the endpoint node. The processor-based device is further configured to traverse, by executing the SoC validator, the endpoint tree data structure from the root node to the endpoint node based on the path. The processor-based device is also configured to retrieve, by executing the SoC validator, value data for the endpoint node based on the traversal. The processor-based device is additionally configured to generate, by executing the SoC validator, an endpoint object representing the endpoint using the value data. The processor-based device is further configured to perform, by executing the SoC validator, an access operation on the endpoint using the endpoint object.

In another exemplary embodiment, a method for dynamically loading endpoint data during SoC validation in processor-based devices is provided. The method comprises obtaining, by an SoC validator executing on a processor-based device, a path for an endpoint node, corresponding to an endpoint of a plurality of endpoints of an SoC, of a plurality of nodes of an endpoint tree data structure, wherein the path comprises a plurality of node identifiers comprising a root node identifier of a root node of the plurality of nodes, one or more intermediate node identifiers of a corresponding one or more intermediate nodes of the plurality of nodes, and an endpoint node identifier of the endpoint node, and the path corresponds to a hierarchical path from the root node of the endpoint tree data structure to the endpoint node. The method further comprises traversing, by the SoC validator, the endpoint tree data structure from the root node to the endpoint node based on the path. The method also comprises retrieving, by the SoC validator, value data for the endpoint node based on the traversal. The method additionally comprises generating, by the SoC validator, an endpoint object representing the endpoint using the value data. The method further comprises performing, by the SoC validator, an access operation on the endpoint using the endpoint object.

In another exemplary embodiment, a non-transitory computer-readable medium is provided, the computer-readable medium having stored thereon computer-executable instructions which, when executed by a processor device of a processor-based device, cause the processor device to obtain a path for an endpoint node, corresponding to an endpoint of a plurality of endpoints of an SoC, of a plurality of nodes of an endpoint tree data structure, wherein the path comprises a plurality of node identifiers comprising a root node identifier of a root node of the plurality of nodes, one or more intermediate node identifiers of a corresponding one or more intermediate nodes of the plurality of nodes, and an endpoint node identifier of the endpoint node, and the path corresponds to a hierarchical path from the root node of the endpoint tree data structure to the endpoint node. The computer-executable instructions further cause the processor device to traverse the endpoint tree data structure from the root node to the endpoint node based on the path. The computer-executable instructions also cause the processor device to retrieve value data for the endpoint node based on the traversal. The computer-executable instructions additionally cause the processor device to generate an endpoint object representing the endpoint using the value data. The computer-executable instructions further cause the processor device to perform an access operation on the endpoint using the endpoint object.

Those skilled in the art will appreciate the scope of the present disclosure and realize additional embodiments thereof after reading the following detailed description of the preferred embodiments in association with the accompanying drawing figures.

### Brief Description of the Drawing Figures

The accompanying drawing figures incorporated in and forming a part of this specification illustrate several embodiments of the disclosure, and together with the description serve to explain the principles of the disclosure:
Figure 1 is a block diagram of an exemplary processor-based device that includes a processor-based device configured to dynamically load endpoint data during System-on-Chip (SoC) validation;
Figure 2 is a diagram providing a logical representation of an exemplary endpoint tree data structure that may be traversed by the SoC validator of Figure 1 to generate the endpoint object of Figure 1, along with an exemplary endpoint tree database that stores the data defining the endpoint tree data structure, according to some embodiments;
Figures 3A-3B provide a flowchart illustrating exemplary operations of the processor device of Figure 1 for dynamically loading endpoint data during SoC validation, according to some embodiments; and
Figure 4 is a block diagram of an exemplary processor-based device, such as the processor-based device of Figure 1, that is configured to dynamically load endpoint data during SoC validation.

### Detailed Description

Exemplary embodiments disclosed herein dynamically load endpoint data during System-on-Chip (SoC) validation in processor devices. In this regard, in one exemplary embodiment, a processor-based device is communicatively coupled to an SoC and is configured to execute an SoC validator to perform validation and/or debugging operations on the SoC. In exemplary operation, the SoC validator obtains a path for an endpoint node of an endpoint tree data structure comprising a plurality of nodes including the endpoint node. In some embodiments, the endpoint node corresponds to an architectural endpoint of the SoC, which may comprise, e.g., a register, a field, or memory of the SoC accessed via a Joint Test Action Group (JTAG) port. The path obtained by the SoC may comprise a plurality of node identifiers including a root node identifier of a root node, one or more intermediate node identifiers of a corresponding one or more intermediate nodes, and an endpoint node identifier of the endpoint node. Some aspects may provide that the path corresponds to a hierarchical path from the root node of the endpoint tree data structure to the endpoint node (reflecting a path of a signal from a debugger entry point of the SoC to the endpoint).

The SoC validator next traverses the endpoint tree data structure from the root node to the endpoint node based on the path. Upon reaching the endpoint node, the SoC validator retrieves value data for the endpoint node based on the traversal. The value data includes all data required to generate an endpoint object, and may comprise, e.g., an endpoint name, a field identifier, a field read/write indicator, a current value of a field, and/or a child node name, as non-limiting examples. The SoC validator then generates an endpoint object representing the endpoint using the value data. The endpoint object according to some embodiments may comprise a Python object. In some embodiments, the operations for generating the endpoint object may comprise the SoC validator initializing one or more object attributes of the endpoint object based on the value data. The SoC validator then performs an access operation on the endpoint using the endpoint object. By dynamically loading only data for the endpoint and generating the single endpoint object on-demand (instead of generating endpoint objects for all of the endpoints during initialization), the startup time, memory consumption, and overall efficiency of the SoC validator is improved.

Some embodiments may provide that, prior to the SoC validator obtaining the path, an endpoint database that comprises data that defines the plurality of endpoints of the SoC may be converted into the endpoint tree data structure having a topology defined by hierarchical relationships among the plurality of endpoints of the SoC. The data defining the endpoint tree data structure is then stored in an endpoint tree database, which is subsequently accessed by the SoC validator during traversal of the endpoint tree data structure. In some embodiments, the endpoint tree database may comprise a lightweight, local disk database such as a Lightning Memory-Mapped Database (LMDB).

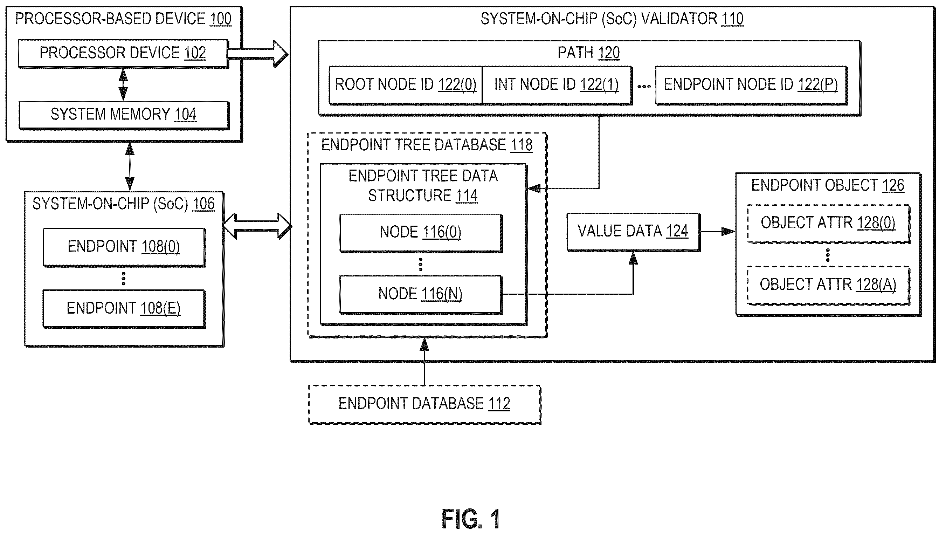

In this regard, Figure 1 illustrates an exemplary processor-based device 100 that includes a processor device 102 that is communicatively coupled to a system memory 104. The processor device 102 may comprise one or more processor cores (not shown), each of which may include an instruction processing circuit (not shown) comprising an execution pipeline (not shown) for executing computer instructions. It is to be understood that some embodiments of the processor-based device 100 may comprise multiple processor devices 102 rather than the single processor device 102 shown in the example of Figure 1, and further that the processor-based device 100 may be one of multiple processor-based devices 100, e.g., organized as a cluster.

The processor-based device 100 is communicatively coupled to an SoC (captioned as "SYSTEM-ON-CHIP (SoC)" in Figure 1) 106 that comprises a plurality of endpoints 108(0)-108(E). In some embodiments, each of the endpoints 108(0)-108(E) comprises an architectural endpoint of the SoC, such as a register, a field, or memory of the SoC accessed via a JTAG port (not shown), as non-limiting examples. A "register" endpoint, as used herein, refers to a memory-mapped control-and-status register (CSR) of the SoC 106, representing a unit of read/write operations. A "field" endpoint, as used herein, refers to a subcomponent of a memory block, bounded by bit value ranges (e.g., in little-endian format). A "memory" endpoint, as used herein, refers to a block of memory addresses of a memory of the SoC 106. The processor-based device 100 of Figure 1 is configured to perform SoC validation and debugging of the SoC 106 by executing an SoC validator (captioned as "SYSTEM-ON-CHIP (SoC) VALIDATOR" in Figure 1) 110.

The processor-based device 100 of Figure 1 and the constituent elements thereof may encompass any one of known digital logic elements, semiconductor circuits, processing cores, and/or memory structures, among other elements, or combinations thereof. Embodiments described herein are not restricted to any particular arrangement of elements, and the disclosed techniques may be easily extended to various structures and layouts on semiconductor sockets or packages. It is to be understood that some embodiments of the processor-based device 100 and the SoC 106 may include elements in addition to those illustrated in Figure 1. For example, the processor device 102 and/or the SoC 106 may further include one or more instruction caches, unified caches, controller circuits, interconnect buses, and/or additional memory devices, caches, and/or controller circuits.

As noted above, the SoC validator 110 may need to access the endpoints 108(0)-108(E) (such as debug and status registers) of the SoC 106 during the process of validating the SoC 106. Conventional approaches to SoC validation may employ a static endpoint database 112, which is pre-generated based on the design specifications of the SoC and that stores data describing the characteristics of each of the endpoints 108(0)-108(E), to generate an object (not shown) for each endpoint 108(0)-108(E) before validation begins. However, some SoCs may comprise a large number of endpoints 108(0)-108(E) (e.g., millions to tens of millions or more). If conventional SoC approaches are used, the SoC validator 110 may incur a severe delay due to the need to construct objects for all possible endpoints 108(0)-108(E) during initialization.

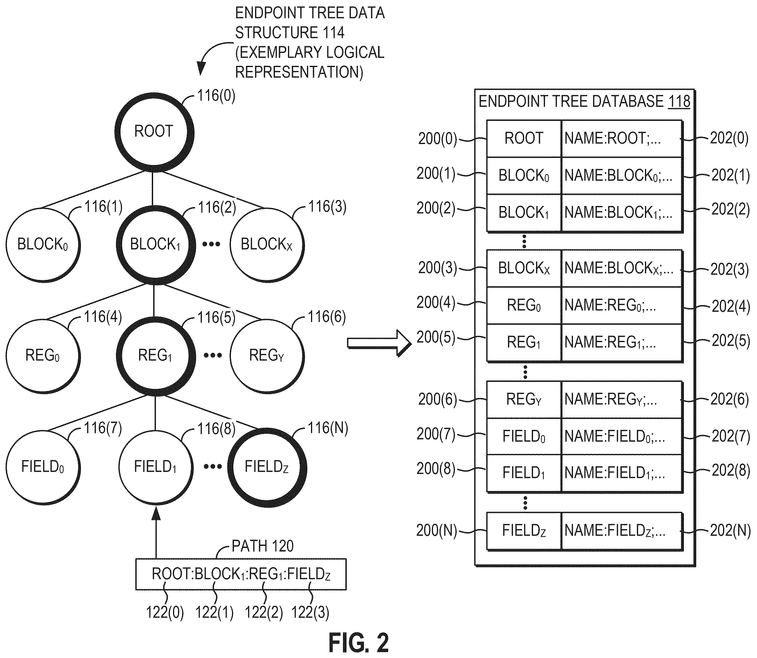

Accordingly, embodiments disclosed herein are configured to dynamically load endpoint data during SoC validation. In some embodiments, the endpoint database 112 is converted into an endpoint tree data structure 114, which is a normalized tree comprising a plurality of nodes 116(0)-116(N) and having a topology that is defined by hierarchical relationships among the endpoints 108(0)-108(E) of the SoC 106. The data defining the endpoint tree data structure 114 in such embodiments may then be stored in an endpoint tree database 118. Some embodiments may provide that the endpoint tree database 118 may comprise a lightweight, local disk database such as a LMDB, as a non-limiting example. Exemplary contents of the endpoint tree database 118 are illustrated and discussed in greater detail below further below with respect to Figure 2.

The plurality of nodes 116(0)-116(N) includes endpoint nodes (not shown) corresponding to each of the endpoints 108(0)-108(E) of the SoC 106. The nodes 116(0)-116(N) further include a root node (not shown) as well as intermediate nodes or "blocks" (not shown) that are used to organize the endpoint tree data structure 114 into a hierarchy corresponding to paths of signals from a debugger entry point (not shown) of the SoC 106 to each of the endpoints 108(0)-108(E). The structure of the endpoint tree data structure 114 according to some embodiments is illustrated and discussed in greater detail below with respect to Figure 2. Each of the nodes 116(0)-116(N) corresponding to the endpoints 108(0)-108(E) may comprise attributes of the corresponding endpoint 108(0)-108(E) and methods that enable reading values from and/or assigning values to the corresponding endpoint 108(0)-108(E).

In exemplary operation, the SoC validator 110 obtains a path 120 for an endpoint node, such as the node 116(N), of the plurality of nodes 116(0)-116(N), wherein the endpoint node 116(N) corresponds to an endpoint (e.g., the endpoint 108(E)) of the plurality of endpoints 108(0)-108(E) of the SoC 106. The path 120 may be obtained, e.g., based on data in the endpoint database 112, and/or by accessing a search method provided by the root node of the endpoint tree data structure 114, as non-limiting examples. The path 120 comprises a root node identifier (captioned as "ROOT NODE ID" in Figure 1) 122(0) of the root node of the plurality of nodes 116(0)-116(N), one or more intermediate node identifiers (captioned as "INT NODE ID" in Figure 1) 122(1) of a corresponding one or more intermediate nodes of the plurality of nodes 116(0)-116(N), and an endpoint node identifier (captioned as "ENDPOINT NODE ID" in Figure 1) 122(P) of the endpoint node 116(N). The root node identifier 122(0), the one or more intermediate node identifiers 122(1), and the endpoint node identifier 122(P) are collectively referred to herein as "node identifiers 122(0)-122(P)."

The SoC validator 110 next traverses the endpoint tree data structure 114 from the root node to the endpoint node 116(N) based on the path 120, and retrieves value data 124 for the endpoint node 116(N) based on the traversal. The SoC validator 110 uses the value data 124 to generate an endpoint object 126 (e.g., a Python object, in some embodiments) that represents the endpoint 108(E). The endpoint object 126 in some embodiments comprises a plurality of object attributes (captioned as "OBJECT ATTR" in Figure 1) 128(0)-128(A) that may be initialized based on the value data 124. The SoC validator 110 then performs an access operation on the endpoint 108(E) using the endpoint object 126. By dynamically loading only data for the endpoint 108(E) and generating the endpoint object 126 on-demand (instead of generating endpoint objects for all of the endpoints 108(0)-108(E) during initialization), the startup time and overall efficiency of the SoC validator 110 is improved.

To illustrate in greater detail the endpoint tree data structure 114 and the endpoint database 112 according to some embodiments, Figure 2 is provided. In Figure 2, an exemplary logical representation of the endpoint tree data structure 114 is provided. It is to be understood that some embodiments may provide an endpoint tree data structure that includes more or fewer elements than the endpoint tree data structure 114 illustrated in Figure 2. The endpoint tree data structure 114 of Figure 2 is a normalized tree that includes the plurality of nodes 116(0)-116(N) of Figure 1 arranged in a hierarchy that reflects the hierarchical relationships among the endpoints 108(0)-108(E) of the SoC 106 of Figure 1. The node 116(0), captioned as "ROOT" in Figure 2 and referred to herein as "root node 116(0)," is the root of the endpoint tree data structure 114, and serves as the common starting point for traversing the endpoint tree data structure 114. Below the root node 116(0) are nodes 116(1)-116(3), captioned as "BLOCK₀," "BLOCK₁," and "BLOCK_{X}," respectively, and referred to herein as "intermediate nodes 116(1)-116(3)," which are child nodes of the root node 116(0). The intermediate nodes 116(1)-116(3) serve to implement the hierarchical structure of the endpoint tree data structure 114, and as such, do not correspond to any physical elements of the SoC 106 of Figure 1.

In the example of Figure 2, the intermediate node 116(2) has child nodes 116(4)-116(6), which are captioned as "REG₀," "REG₁," and "REG_{Y}," respectively, and referred to herein as "register nodes 116(4)-116(6)." The register nodes 116(4)-116(6) represent corresponding register endpoints among the endpoints 108(0)-108(E) of Figure 1. Similarly, the register node 116(5) has child nodes 116(7)-116(N), which are captioned as "FIELD₀," "FIELD₁," and "FIELD_{Z}," respectively, and referred to herein as "field nodes 116(7)-116(N)." The field nodes 116(7)-116(N) represent corresponding field endpoints among the endpoints 108(0)-108(E), and represent fields of the register endpoint corresponding to the register node 116(5). It is to be understood that the endpoint tree data structure 114 in some embodiments may include nodes that correspond to memory endpoints among the endpoints 108(0)-108(E) of Figure 1.

The data defining the endpoint tree data structure 114 may be stored in the endpoint tree database 118 as shown in Figure 2. In the example of Figure 2, the endpoint tree database 118 stores a plurality of keys 200(0)-200(N) and corresponding value data 202(0)-202(N). Each of the keys 200(0)-200(N) denotes a unique identifier of a corresponding node 116(0)-116(N), while the value data 202(0)-202(N) each denotes attribute information for the corresponding node 116(0)-116(N). For endpoint nodes such as the register nodes 116(4)-116(6) and the field nodes 116(7)-116(N), the value data 202(4)-202(N) includes all data needed to instantiate an endpoint object such as the endpoint object 126 of Figure 1, and may comprise one or more of an endpoint name, a field identifier, a field read/write indicator, a current value of a field, and a child node name, as non-limiting examples. The value data 202(0)-202(3) corresponding to the root node 116(0) and the intermediate nodes 116(1)-116(3) may include, e.g., a node name and a child node name.

As seen in Figure 2, an exemplary path 120 that may be obtained by the SoC validator 110 of Figure 1 may be used to traverse the endpoint tree data structure 114 to access the endpoint (such as the endpoint 108(E) of Figure 1) corresponding to the field node 116(N). The path 120 in this example includes a root node identifier 122(0) corresponding to the root node 116(0), an intermediate node identifier 122(1) corresponding to the intermediate node 116(2), an endpoint node identifier 122(2) corresponding to the register node 116(5), and an endpoint node identifier 122(3) corresponding to the field node 116(N). The SoC validator 110 uses the path 120 to traverse the endpoint tree data structure 114 following the emphasized nodes 116(0), 116(2), 116(5), and 116(N). Upon reading the endpoint node 116(N), the SoC validator 110 retrieves the corresponding value data 202(N) (i.e., the value data 124 of Figure 1), and uses the value data 202(N) to generate the endpoint object 126 of Figure 1.

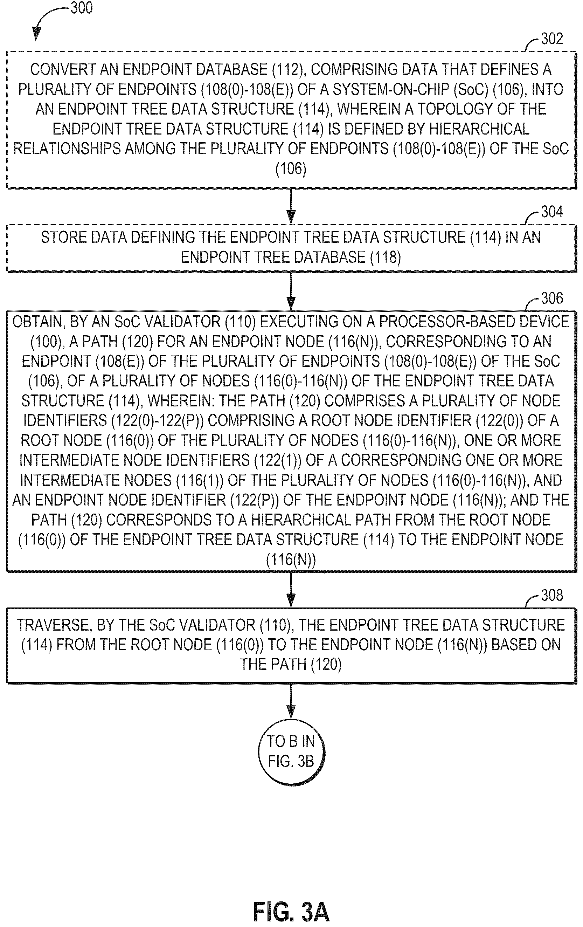

Figures 3A-3B provide a flowchart illustrating exemplary operations 300 of the processor-based device 100 of Figure 1 for dynamically loading endpoint data during SoC validation, according to some embodiments. For the sake of clarity, elements of Figures 1 and 2 are referenced in describing Figures 3A-3B. It is to be understood that some operations illustrated in Figures 3A-3B may occur in an order other than that illustrated in Figures 3A-3B in some embodiments, and/or may be omitted in some

According to some embodiments, the exemplary operations 300 begin in Figure 3A with converting an endpoint database (e.g., the endpoint database 112 of Figure 1), comprising data that defines a plurality of endpoints (such as the endpoints 108(0)-108(E) of Figure 1) of an SoC (e.g., the SoC 106 of Figure 1), into an endpoint tree data structure (such as the endpoint tree data structure 114 of Figure 1), wherein a topology of the endpoint tree data structure 114 is defined by hierarchical relationships among the plurality of endpoints 108(0)-108(E) of the SoC 106 (block 302). The data defining the endpoint tree data structure 114 is then stored in an endpoint tree database (e.g., the endpoint tree database 118 of Figure 1) (block 304).

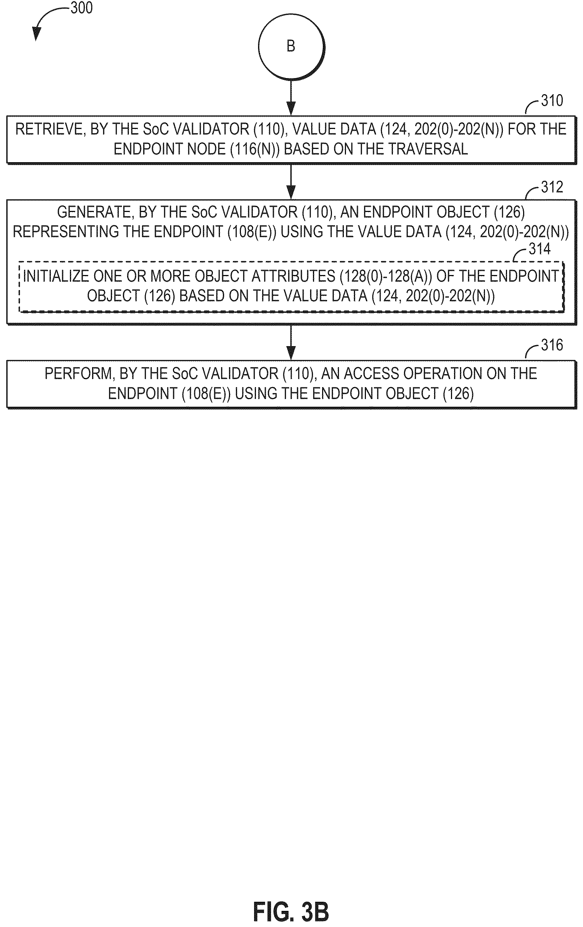

An SoC validator (such as the SoC validator 110 of Figure 1) executing on a processor-based device (e.g., the processor-based device 100 of Figure 1) obtains a path (such as the path 120 of Figure 1) for an endpoint node (e.g., the endpoint node 116(N) of Figures 1 and 2), corresponding to an endpoint (such as the endpoint 108(E) of Figure 1) of the plurality of endpoints 108(0)-108(E) of the SoC 106, of a plurality of nodes (e.g., the nodes 116(0)-116(N) of Figures 1 and 2) of the endpoint tree data structure 114 (block 306). As discussed above, the path 120 comprises a plurality of node identifiers (such as the node identifiers 122(0)-122(P) of Figure 1) comprising a root node identifier (e.g., the root node identifier 122(0) of Figure 1) of a root node (such as the root node 116(0) of Figure 2) of the plurality of nodes 116(0)-116(N), one or more intermediate node identifiers (such as the intermediate node identifiers 122(1) of Figure 1) of a corresponding one or more intermediate nodes (e.g., the intermediate node 116(1) of Figure 2) of the plurality of nodes 116(0)-116(N), and an endpoint node identifier (such as the endpoint node identifier 122(P) of Figure 1) of the endpoint node 116(N). The path 120 corresponds to a hierarchical path from the root node 116(0) of the endpoint tree data structure 114 to the endpoint node 116(N). The SoC validator 110 next traverses the endpoint tree data structure 114 from the root node 116(0) to the endpoint node 116(N) based on the path 120 (block 308). The exemplary operations 300 then continue at block 310 of Figure 3B.

Referring now to Figure 3B, the SoC validator 110 retrieves value data (e.g., the value data 124 and 202(0)-202(N) of Figures 1 and 2) for the endpoint node 116(N) based on the traversal (block 310). The SoC validator 110 next generates an endpoint object (such as the endpoint object 126 of Figure 1) representing the endpoint 108(E) using the value data 124, 202(0)-202(N) (block 312). In some embodiments, the operations of block 312 for generating the endpoint object 126 may comprise the SoC validator 110 initializing one or more object attributes (e.g., the object attributes 128(0)-128(A) of Figure 1) of the endpoint object 126 based on the value data 124, 202(0)-202(N) (block 314). The SoC validator 110 then performs an access operation on the endpoint 108(E) using the endpoint object 126 (block 316).

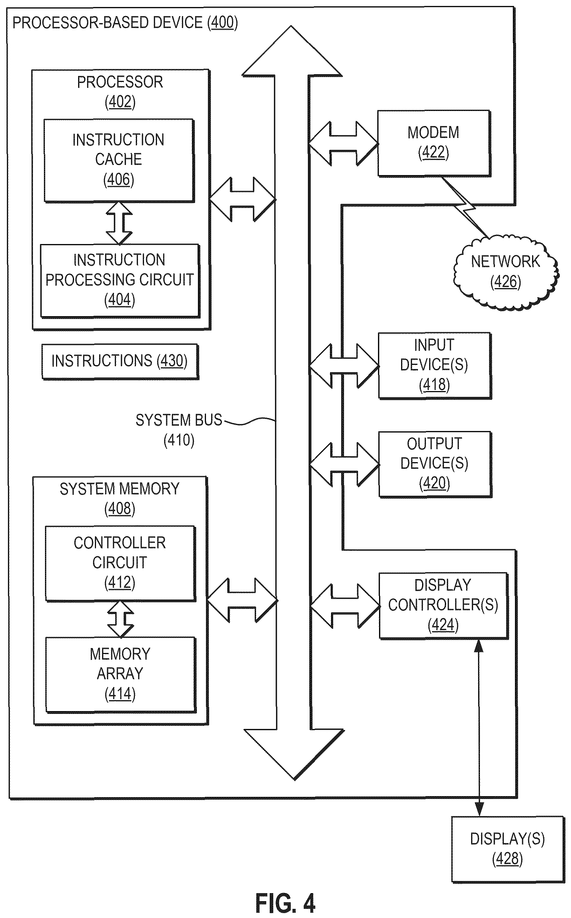

Figure 4 is a block diagram of an exemplary processor-based device 400 that includes a processor 402 (e.g., a microprocessor) that includes an instruction processing circuit 404. The processor-based device 400 can be the processor-based device 100 in Figure 1 as an example. The processor-based device 400 may be a circuit or circuits included in an electronic board card, such as a printed circuit board (PCB), a server, a personal computer, a desktop computer, a laptop computer, a personal digital assistant (PDA), a computing pad, a mobile device, or any other device, and may represent, for example, a server, or a user's computer.

In this example, the processor 402 represents one or more general-purpose processing circuits, such as a microprocessor, central processing unit, or the like. The processor 402 is configured to execute processing logic in instructions for performing the operations and steps discussed herein. In this example, the processor 402 includes an instruction cache 406 for temporary, fast access memory storage of instructions accessible by the instruction processing circuit 404. Fetched or prefetched instructions from a memory, such as from the system memory 408 over a system bus 410, are stored in the instruction cache 406. The instruction processing circuit 404 is configured to process instructions fetched into the instruction cache 406 and process the instructions for execution.

The processor 402 and the system memory 408 are coupled to the system bus 410 and can intercouple peripheral devices included in the processor-based device 400. As is well known, the processor 402 communicates with these other devices by exchanging address, control, and data information over the system bus 410. For example, the processor 402 can communicate bus transaction requests to a controller circuit 412 in the system memory 408 as an example of a subordinate device. Although not illustrated in Figure 4, multiple system buses 410 could be provided, wherein each system bus constitutes a different fabric. In this example, the controller circuit 412 is configured to provide memory access requests to a memory array 414 in the system memory 408. The memory array 414 is comprised of an array of storage bit cells for storing data. The system memory 408 may be a read-only memory (ROM), flash memory, dynamic random access memory (DRAM), such as synchronous DRAM (SDRAM), etc., and a static memory (e.g., flash memory, static random access memory (SRAM), etc.), as non-limiting examples.

Other devices can be connected to the system bus 410. As illustrated in Figure 4, these devices can include the system memory 408, one or more input device(s) 418, one or more output device(s) 420, a modem 422, and one or more display controllers 424, as examples. The input device(s) 418 can include any type of input device, including but not limited to input keys, switches, voice processors, etc. The output device(s) 420 can include any type of output device, including but not limited to audio, video, other visual indicators, etc. The modem 422 can be any device configured to allow exchange of data to and from a network 426. The network 426 can be any type of network, including but not limited to a wired or wireless network, a private or public network, a local area network (LAN), a wireless local area network (WLAN), a wide area network (WAN), a BLUETOOTH^{™} network, and the Internet. The modem 422 can be configured to support any type of communications protocol desired. The processor 402 may also be configured to access the display controller(s) 424 over the system bus 410 to control information sent to one or more displays 428. The display(s) 428 can include any type of display, including but not limited to a cathode ray tube (CRT), a liquid crystal display (LCD), a plasma display, etc.

The processor-based device 400 in Figure 4 may include a set of instructions 430 to be executed by the processor 402 for any application desired according to the instructions. The instructions 430 may be stored in the system memory 408, processor 402, and/or instruction cache 406 as examples of a non-transitory computer-readable medium. The instructions 430 may also reside, completely or at least partially, within the system memory 408 and/or within the processor 402 during their execution. The instructions 430 may further be transmitted or received over the network 426 via the modem 422.

While the computer-readable medium is described herein in an exemplary embodiment to be a single medium, the term "computer-readable medium" should be taken to include a single medium or multiple media (e.g., a centralized or distributed database, and/or associated caches and servers) that stores the one or more sets of instructions. The term "computer-readable medium" shall also be taken to include any medium that is capable of storing, encoding, or carrying a set of instructions for execution by the processing device and that causes the processing device to perform any one or more of the methodologies of the embodiments disclosed herein. The term "computer-readable medium" shall accordingly be taken to include, but not be limited to, solid-state memories, optical medium, and magnetic medium.

The embodiments disclosed herein include various steps. The steps of the embodiments disclosed herein may be formed by hardware components or may be embodied in machine-executable instructions, which may be used to cause a general-purpose or special-purpose processor programmed with the instructions to perform the steps. Alternatively, the steps may be performed by a combination of hardware and software process.

The embodiments disclosed herein may be provided as a computer program product, or software process, that may include a machine-readable medium (or computer-readable medium) having stored thereon instructions, which may be used to program a computer system (or other electronic devices) to perform a process according to the embodiments disclosed herein. A machine-readable medium includes any mechanism for storing or transmitting information in a form readable by a machine (e.g., a computer). For example, a machine-readable medium includes: a machine-readable storage medium (e.g., ROM, random access memory ("RAM"), a magnetic disk storage medium, an optical storage medium, flash memory devices, etc.), and the like.

Unless specifically stated otherwise and as apparent from the previous discussion, it is appreciated that throughout the description, discussions utilizing terms such as "processing," "computing," "determining," "displaying," or the like, refer to the action and processes of a computer system, or similar electronic computing device, that manipulates and transforms data and memories represented as physical (electronic) quantities within the computer system's registers into other data similarly represented as physical quantities within the computer system memories or registers or other such information storage, transmission, or display devices.

The algorithms and displays presented herein are not inherently related to any particular computer or other apparatus. Various systems may be used with programs in accordance with the teachings herein, or it may prove convenient to construct more specialized apparatuses to perform the required method steps. The required structure for a variety of these systems will appear from the description above. In addition, the embodiments described herein are not described with reference to any particular programming language. It will be appreciated that a variety of programming languages may be used to implement the teachings of the embodiments as described herein.

Those of skill in the art will further appreciate that the various illustrative logical blocks, modules, circuits, and algorithms described in connection with the embodiments disclosed herein may be implemented as electronic hardware, instructions stored in memory or in another computer-readable medium and executed by a processor or other processing device, or combinations of both. The components of the processor-based devices described herein may be employed in any circuit, hardware component, integrated circuit (IC), or IC chip, as examples. Memory disclosed herein may be any type and size of memory and may be configured to store any type of information desired. To clearly illustrate this interchangeability, various illustrative components, blocks, modules, circuits, and steps have been described above generally in terms of their functionality. How such functionality is implemented depends on the particular application, design choices, and/or design constraints imposed on the overall system. Skilled artisans may implement the described functionality in varying ways for each particular application, but such implementation decisions should not be interpreted as causing a departure from the scope of the present embodiments.

The various illustrative logical blocks, modules, and circuits described in connection with the embodiments disclosed herein may be implemented or performed with a processor, a Digital Signal Processor (DSP), an Application Specific Integrated Circuit (ASIC), a Field Programmable Gate Array (FPGA), or other programmable logic device, a discrete gate or transistor logic, discrete hardware components, or any combination thereof designed to perform the functions described herein. Furthermore, a controller may be a processor. A processor may be a microprocessor, but in the alternative, the processor may be any conventional processor, controller, microcontroller, or state machine. A processor may also be implemented as a combination of computing devices (e.g., a combination of a DSP and a microprocessor, a plurality of microprocessors, one or more microprocessors in conjunction with a DSP core, or any other such configuration).

The embodiments disclosed herein may be embodied in hardware and in instructions that are stored in hardware, and may reside, for example, in RAM, flash memory, ROM, Electrically Programmable ROM (EPROM), Electrically Erasable Programmable ROM (EEPROM), registers, a hard disk, a removable disk, a CD-ROM, or any other form of computer-readable medium known in the art. An exemplary storage medium is coupled to the processor such that the processor can read information from, and write information to, the storage medium. In the alternative, the storage medium may be integral to the processor. The processor and the storage medium may reside in an ASIC. The ASIC may reside in a remote station. In the alternative, the processor and the storage medium may reside as discrete components in a remote station, base station, or server.

It is also noted that the operational steps described in any of the exemplary embodiments herein are described to provide examples and discussion. The operations described may be performed in numerous different sequences other than the illustrated sequences. Furthermore, operations described in a single operational step may actually be performed in a number of different steps. Additionally, one or more operational steps discussed in the exemplary embodiments may be combined. Those of skill in the art will also understand that information and signals may be represented using any of a variety of technologies and techniques. For example, data, instructions, commands, information, signals, bits, symbols, and chips, that may be references throughout the above description, may be represented by voltages, currents, electromagnetic waves, magnetic fields, or particles, optical fields or particles, or any combination thereof.

Unless otherwise expressly stated, it is in no way intended that any method set forth herein be construed as requiring that its steps be performed in a specific order. Accordingly, where a method claim does not actually recite an order to be followed by its steps, or it is not otherwise specifically stated in the claims or descriptions that the steps are to be limited to a specific order, it is in no way intended that any particular order be inferred.

It will be apparent to those skilled in the art that various modifications and variations can be made without departing from the spirit or scope of the invention. Since modifications, combinations, sub-combinations and variations of the disclosed embodiments incorporating the spirit and substance of the invention may occur to persons skilled in the art, the invention should be construed to include everything within the scope of the appended claims and their equivalents.

Dynamically loading endpoint data during System-on-Chip (SoC) validation in processor-based devices is disclosed herein. In one exemplary embodiment, a processor-based device, by executing an SoC validator, obtains a path for an endpoint node of an endpoint tree data structure. The path comprises node identifiers including a root node identifier of a root node, intermediate node identifiers of corresponding intermediate nodes, and an endpoint node identifier of the endpoint node, and corresponds to a hierarchical path from the root node of the endpoint tree data structure to the endpoint node. The SoC validator traverses the endpoint tree data structure from the root node to the endpoint node based on the path, and retrieves value data for the endpoint node based on the traversal. The SoC validator then generates an endpoint object representing the endpoint using the value data, and performs an access operation on an endpoint using the endpoint object.

In an example, there is provided a processor-based device, configured to: obtain, by executing a System-on-Chip (SoC) validator, a path for an endpoint node, corresponding to an endpoint of a plurality of endpoints of an SoC, of a plurality of nodes of an endpoint tree data structure, wherein: the path comprises a plurality of node identifiers comprising a root node identifier of a root node of the plurality of nodes, one or more intermediate node identifiers of a corresponding one or more intermediate nodes of the plurality of nodes, and an endpoint node identifier of the endpoint node; and the path corresponds to a hierarchical path from the root node of the endpoint tree data structure to the endpoint node; traverse, by executing the SoC validator, the endpoint tree data structure from the root node to the endpoint node based on the path; retrieve, by executing the SoC validator, value data for the endpoint node based on the traversal; generate, by executing the SoC validator, an endpoint object representing the endpoint using the value data; and perform, by executing the SoC validator, an access operation on the endpoint using the endpoint object.

In an example, the endpoint node corresponds to an architectural endpoint of the SoC.

In an example, the processor-based device is further configured to, prior to obtaining the path for the endpoint node: convert an endpoint database, comprising data that defines the plurality of endpoints of the SoC, into the endpoint tree data structure, wherein a topology of the endpoint tree data structure is defined by hierarchical relationships among the plurality of endpoints of the SoC; and store data defining the endpoint tree data structure in an endpoint tree database.

In an example, the endpoint tree database comprises a Lightning Memory-Mapped Database (LMDB).

In an example, each of the plurality of endpoints comprises one of a register, a register field, and memory.

In an example, the processor-based device is configured to generate the endpoint object representing the endpoint using the value data by being configured to initialize one or more object attributes of the endpoint object based on the value data.

In an example, the value data comprises one or more of an endpoint name, a register field identifier, a register field read/write indicator, a current value of a register field, and a child node name.

In an example, the endpoint object comprises a Python object.

In an example, there is provided a method for dynamically loading endpoint data during System-on-Chip (SoC) validation in processor-based devices, comprising: obtaining, by an SoC validator executing on a processor-based device, a path for an endpoint node, corresponding to an endpoint of a plurality of endpoints of an SoC, of a plurality of nodes of an endpoint tree data structure, wherein: the path comprises a plurality of node identifiers comprising a root node identifier of a root node of the plurality of nodes, one or more intermediate node identifiers of a corresponding one or more intermediate nodes of the plurality of nodes, and an endpoint node identifier of the endpoint node; and the path corresponds to a hierarchical path from the root node of the endpoint tree data structure to the endpoint node; traversing, by the SoC validator, the endpoint tree data structure from the root node to the endpoint node based on the path; retrieving, by the SoC validator, value data for the endpoint node based on the traversal; generating, by the SoC validator, an endpoint object representing the endpoint using the value data; and performing, by the SoC validator, an access operation on the endpoint using the endpoint object.

In an example, the endpoint node corresponds to an architectural endpoint of the SoC.

In an example, the method further comprises, prior to obtaining the path for the endpoint node: converting an endpoint database, comprising data that defines the plurality of endpoints of the SoC, into the endpoint tree data structure, wherein a topology of the endpoint tree data structure is defined by hierarchical relationships among the plurality of endpoints of the SoC; and storing data defining the endpoint tree data structure in an endpoint tree database.

In an example, the endpoint tree database comprises a Lightning Memory-Mapped Database (LMDB).

In an example, each of the plurality of endpoints comprises one of a register, a register field, and memory.

In an example, generating the endpoint object representing the endpoint using the value data comprises initializing one or more object attributes of the endpoint object based on the value data.

In an example, the value data comprises one or more of an endpoint name, a register field identifier, a register field read/write indicator, a current value of a register field, and a child node name.

In an example, the endpoint object comprises a Python object.

In an example, there is provided a non-transitory computer-readable medium, having stored thereon computer-executable instructions that, when executed by a processor device of a processor-based device, causes the processor device to: obtain a path for an endpoint node, corresponding to an endpoint of a plurality of endpoints of a System-on-Chip (SoC), of a plurality of nodes of an endpoint tree data structure, wherein: the path comprises a plurality of node identifiers comprising a root node identifier of a root node of the plurality of nodes, one or more intermediate node identifiers of a corresponding one or more intermediate nodes of the plurality of nodes, and an endpoint node identifier of the endpoint node; and the path corresponds to a hierarchical path from the root node of the endpoint tree data structure to the endpoint node; traverse the endpoint tree data structure from the root node to the endpoint node based on the path; retrieve value data for the endpoint node based on the traversal; generate an endpoint object representing the endpoint using the value data; and perform an access operation on the endpoint using the endpoint object.

In an example, the computer-executable instructions further cause the processor device to, prior to obtaining the path for the endpoint node: convert an endpoint database, comprising data that defines the plurality of endpoints of the SoC, into the endpoint tree data structure, wherein a topology of the endpoint tree data structure is defined by hierarchical relationships among the plurality of endpoints of the SoC; and store data defining the endpoint tree data structure in an endpoint tree database.

In an example, the computer-executable instructions cause the processor device to generate the endpoint object representing the endpoint using the value data by causing the processor device to initialize one or more object attributes of the endpoint object based on the value data.

In an example, the value data comprises one or more of an endpoint name, a register field identifier, a register field read/write indicator, a current value of a register field, and a child node name.

In an example, there is provided a method, comprising: obtaining an endpoint path for an endpoint node that is included in an endpoint tree data structure having a hierarchical structure, the endpoint tree data structure comprising a root node and an endpoint node, the endpoint node corresponding to an endpoint of a system-on-chip (SoC); traversing, according to the endpoint path, the endpoint tree data structure from the root node to the endpoint node; in response to the traversal to the endpoint node: retrieving value data, the value data comprising at least one of: an endpoint name of the endpoint of the SoC, a register-field identifier of the endpoint of the SoC, a register field read/write indicator of the endpoint of the SoC, a current value of a field of the endpoint of the SoC, or a child node name of the endpoint of the SoC; and generating, via a processor, an endpoint object from the retrieved value data, the endpoint object comprising object attributes initialized based on the retrieved value data; and initiating an access operation to the endpoint of the SoC, the access operation comprising performing, by the processor, a read operation or a write operation on the endpoint of the SoC according to the object attributes initialized based on the retrieved value data, the access operation to the endpoint of the SoC being usable during SoC validation.

In an example, traversing the endpoint tree data structure comprises traversing an intermediate node specified by the endpoint path, the intermediate node being between the root node and the endpoint node, and wherein the generating of the endpoint object occurs only after the traversal of the endpoint tree data structure reaches the endpoint node.

In an example, traversing the endpoint tree data structure comprises traversing a plurality of intermediate nodes specified by the endpoint path, each of the plurality of intermediate nodes being between the root node and the endpoint node, and wherein the generating of the endpoint object occurs only after the traversal of the endpoint tree data structure reaches the endpoint node.

In an example, the method further comprises receiving a request to access the endpoint, wherein obtaining the endpoint path comprises determining the endpoint path in response to the request to access the endpoint, and wherein the traversal of the endpoint tree data structure in response to the request to access the endpoint is limited to the nodes specified by the endpoint path.

In an example, the method further comprises receiving a request to access the endpoint, wherein obtaining the endpoint path comprises determining the endpoint path from an identifier of the endpoint associated with a request to access the endpoint, by resolving the identifier within the endpoint tree data structure.

In an example, retrieving the value data comprises accessing value data stored separately from the endpoint tree data structure, and wherein the endpoint tree data structure stores identifiers usable to locate the value data.

In an example, the endpoint of the SoC comprises at least one of a register, a register field, or a memory, and wherein the endpoint object includes parameters used to perform the access operation.

In an example, the method further comprises prior to obtaining the endpoint path, generating the endpoint tree data structure from endpoint definition data that enumerates endpoints of the SoC and defines hierarchical relationships among the endpoints of the SoC, the endpoints of the SoC comprising the endpoint of the SoC.

In an example, there is provided a processor-based device, comprising: a processor; and a computer-readable storage medium having encoded thereon computer-executable instructions configured to cause the processor to enable actions, comprising: obtaining an endpoint path for an endpoint node that is included in an endpoint tree data structure having a hierarchical structure, the endpoint tree data structure comprising a root node and an endpoint node, the endpoint node corresponding to an endpoint of a system-on-chip (SoC); traversing, according to the endpoint path, the endpoint tree data structure from the root node to the endpoint node; in response to the traversal to the endpoint node: retrieving value data, the value data comprising at least one of: an endpoint name of the endpoint of the SoC, a register-field identifier of the endpoint of the SoC, a register field read/write indicator of the endpoint of the SoC, a current value of a field of the endpoint of the SoC, or a child node name of the endpoint of the SoC; and generating an endpoint object from the retrieved value data, the endpoint object comprising object attributes initialized based on the retrieved value data; and initiating an access operation to the endpoint of the SoC, the access operation comprising performing, by the processor, a read operation or a write operation on the endpoint of the SoC according to the object attributes initialized based on the retrieved value data, the access operation to the endpoint of the SoC being usable during SoC validation.

In an example, traversing the endpoint tree data structure comprises traversing an intermediate node specified by the endpoint path, the intermediate node being between the root node and the endpoint node, and wherein the generating of the endpoint object occurs only after the traversal of the endpoint tree data structure reaches the endpoint node.

In an example, the actions further comprise receiving a request to access the endpoint, wherein obtaining the endpoint path comprises determining the endpoint path in response to the request to access the endpoint, and wherein the traversal of the endpoint tree data structure in response to the request to access the endpoint is limited to the nodes specified by the endpoint path.

In an example, the actions further comprise receiving a request to access the endpoint, wherein obtaining the endpoint path comprises determining the endpoint path from an identifier of the endpoint associated with a request to access the endpoint, by resolving the identifier within the endpoint tree data structure.

In an example, retrieving the value data comprises accessing value data stored separately from the endpoint tree data structure, and wherein the endpoint tree data structure stores identifiers usable to locate the value data.

In an example, the actions further comprise, prior to obtaining the endpoint path, generating the endpoint tree data structure from endpoint definition data that enumerates endpoints of the SoC and defines hierarchical relationships among the endpoints of the SoC, the endpoints of the SoC comprising the endpoint of the SoC.

In an example, there is provided a computer-readable storage medium (408) having encoded thereon computer-executable instructions configured to cause a processor to enable actions, comprising: obtaining an endpoint path for an endpoint node that is included in an endpoint tree data structure, the endpoint tree data structure comprising a root node and an endpoint node, the endpoint node corresponding to an endpoint of a system-on-chip (SoC); traversing, according to the endpoint path, the endpoint tree data structure from the root node to the endpoint node; in response to the traversal to the endpoint node: retrieving value data, the value data comprising at least one of: an endpoint name of the endpoint of the SoC, a register-field identifier of the endpoint of the SoC, a register field read/write indicator of the endpoint of the SoC, a current value of a field of the endpoint of the SoC, or a child node name of the endpoint of the SoC; and generating an endpoint object from the retrieved value data, the endpoint object comprising object attributes initialized based on the retrieved value data; and initiating an access operation to the endpoint of the SoC, the access operation comprising performing, by the processor, a read operation or a write operation on the endpoint of the SoC according to the object attributes initialized based on the retrieved value data, the access operation to the endpoint of the SoC being usable during SoC validation.

In an example, traversing the endpoint tree data structure comprises traversing an intermediate node specified by the endpoint path, the intermediate node being between the root node and the endpoint node, and wherein the generating of the endpoint object occurs only after the traversal of the endpoint tree data structure reaches the endpoint node.

In an example, the actions further comprise receiving a request to access the endpoint, wherein obtaining the endpoint path comprises determining the endpoint path in response to the request to access the endpoint, and wherein the traversal of the endpoint tree data structure in response to the request to access the endpoint is limited to the nodes specified by the endpoint path.

In an example, the actions further comprise receiving a request to access the endpoint, wherein obtaining the endpoint path comprises determining the endpoint path from an identifier of the endpoint associated with a request to access the endpoint, by resolving the identifier within the endpoint tree data structure.

In an example, retrieving the value data comprises accessing value data stored separately from the endpoint tree data structure, and wherein the endpoint tree data structure stores identifiers usable to locate the value data.

In an example, the actions further comprise, prior to obtaining the endpoint path, generating the endpoint tree data structure from endpoint definition data that enumerates endpoints of the SoC and defines hierarchical relationships among the endpoints of the SoC, the endpoints of the SoC comprising the endpoint of the SoC.

## Claims

1. A method, comprising:
obtaining an endpoint path (120) for an endpoint node (116) that is included in an endpoint tree data structure (114) having a hierarchical structure, the endpoint tree data structure (114) comprising a root node (116) and an endpoint node (116), the endpoint node (116) corresponding to an endpoint (108) of a system-on-chip (SoC) (106);
traversing, according to the endpoint path (120), the endpoint tree data structure (114) from the root node (116) to the endpoint node (116);
in response to the traversal to the endpoint node (116):
retrieving value data (124), the value data (124) comprising at least one of: an endpoint name of the endpoint (108) of the SoC (106), a register-field identifier of the endpoint (108) of the SoC (106), a register field read/write indicator of the endpoint (108) of the SoC (106), a current value of a field of the endpoint (108) of the SoC (106), or a child node name of the endpoint (108) of the SoC (106); and
generating, via a processor (402), an endpoint object (126) from the retrieved value data (124), the endpoint object (126) comprising object attributes initialized based on the retrieved value data (124); and
initiating an access operation to the endpoint (108) of the SoC (106), the access operation comprising performing, by the processor (402), a read operation or a write operation on the endpoint (108) of the SoC (106) according to the object attributes initialized based on the retrieved value data (124), the access operation to the endpoint (108) of the SoC (106) being usable during SoC validation.

2. The method of claim 1, wherein traversing the endpoint tree data structure comprises traversing an intermediate node specified by the endpoint path, the intermediate node being between the root node and the endpoint node, and wherein the generating of the endpoint object occurs only after the traversal of the endpoint tree data structure reaches the endpoint node.

3. The method of claim 1, wherein traversing the endpoint tree data structure comprises traversing a plurality of intermediate nodes specified by the endpoint path, each of the plurality of intermediate nodes being between the root node and the endpoint node, and wherein the generating of the endpoint object occurs only after the traversal of the endpoint tree data structure reaches the endpoint node.

4. The method of any preceding claim, further comprising receiving a request to access the endpoint, wherein obtaining the endpoint path comprises determining the endpoint path in response to the request to access the endpoint, and wherein the traversal of the endpoint tree data structure in response to the request to access the endpoint is limited to the nodes specified by the endpoint path.

5. The method of any preceding claim, further comprising receiving a request to access the endpoint, wherein obtaining the endpoint path comprises determining the endpoint path from an identifier of the endpoint associated with a request to access the endpoint, by resolving the identifier within the endpoint tree data structure.

6. The method of any preceding claim, wherein retrieving the value data comprises accessing value data stored separately from the endpoint tree data structure, and wherein the endpoint tree data structure stores identifiers usable to locate the value data.

7. The method of any preceding claim, wherein the endpoint of the SoC comprises at least one of a register, a register field, or a memory, and wherein the endpoint object includes parameters used to perform the access operation.

8. The method of any preceding claim, further comprising, prior to obtaining the endpoint path, generating the endpoint tree data structure from endpoint definition data that enumerates endpoints of the SoC and defines hierarchical relationships among the endpoints of the SoC, the endpoints of the SoC comprising the endpoint of the SoC.

9. A processor-based device, comprising:
a processor (402); and
a computer-readable storage medium (408) having encoded thereon computer-executable instructions (430) configured to cause the processor (402) to enable actions, comprising:
obtaining an endpoint path (120) for an endpoint node (116) that is included in an endpoint tree data structure (114) having a hierarchical structure, the endpoint tree data structure (114) comprising a root node (116) and an endpoint node (116), the endpoint node (116) corresponding to an endpoint (108) of a system-on-chip (SoC) (106);
traversing, according to the endpoint path (120), the endpoint tree data structure (114) from the root node (116) to the endpoint node (116);
in response to the traversal to the endpoint node (116):
retrieving value data (124), the value data (124) comprising at least one of: an endpoint name of the endpoint (108) of the SoC (106), a register-field identifier of the endpoint (108) of the SoC (106), a register field read/write indicator of the endpoint (108) of the SoC (106), a current value of a field of the endpoint (108) of the SoC (106), or a child node name of the endpoint (108) of the SoC (106); and
generating an endpoint object (126) from the retrieved value data (124), the endpoint object (126) comprising object attributes initialized based on the retrieved value data (124); and
initiating an access operation to the endpoint (108) of the SoC (106), the access operation comprising performing, by the processor (402), a read operation or a write operation on the endpoint (108) of the SoC (106) according to the object attributes initialized based on the retrieved value data (124), the access operation to the endpoint (108) of the SoC (106) being usable during SoC validation.

10. The processor-based device of claim 9, wherein traversing the endpoint tree data structure comprises traversing an intermediate node specified by the endpoint path, the intermediate node being between the root node and the endpoint node, and wherein the generating of the endpoint object occurs only after the traversal of the endpoint tree data structure reaches the endpoint node.

11. The processor-based device of any of claims 9 to 10, the actions further comprising receiving a request to access the endpoint, wherein obtaining the endpoint path comprises determining the endpoint path in response to the request to access the endpoint, and wherein the traversal of the endpoint tree data structure in response to the request to access the endpoint is limited to the nodes specified by the endpoint path.

12. The processor-based device of any of claims 9 to 11, the actions further comprising receiving a request to access the endpoint, wherein obtaining the endpoint path comprises determining the endpoint path from an identifier of the endpoint associated with a request to access the endpoint, by resolving the identifier within the endpoint tree data structure.

13. The processor-based device of any of claims 9 to 12, wherein retrieving the value data comprises accessing value data stored separately from the endpoint tree data structure, and wherein the endpoint tree data structure stores identifiers usable to locate the value data.

14. The processor-based device of any of claims 9 to 13, the actions further comprising, prior to obtaining the endpoint path, generating the endpoint tree data structure from endpoint definition data that enumerates endpoints of the SoC and defines hierarchical relationships among the endpoints of the SoC, the endpoints of the SoC comprising the endpoint of the SoC.

15. A computer-readable storage medium (408) having encoded thereon computer-executable instructions (430) configured to cause a processor (402) to perform a method in accordance with any of claims 1 to 8.
